# EUROPEAN PATENT SPECIFICATION

(11) **EP 3 345 075 B1**
(45) Date of publication and mention of the grant of the patent: **03.07.2019**
(21) Application number: 16760851.2
(22) Date of filing: 09.08.2016
(51) Int. Cl.: G06F 3/01, G06F 1/20, G06F 1/16

(54) **THERMAL MANAGEMENT OF ELECTRONIC HEADSETS**
WÄRMEVERWALTUNG VON ELEKTRONISCHEN HEADSETS
GESTION THERMIQUE DE CASQUES ÉLECTRONIQUES

(30) Priority: 02.09.2015 US 201514843973
(43) Date of publication of application: 11.07.2018
(73) Proprietor: Qualcomm Incorporated, San Diego, CA 92121-1714 (US)
(72) Inventor: RAHIM, Emil, San Diego, California 92121-1714 (US); SAEIDI, Mehdi, San Diego, California 92121-1714 (US); MITTAL, Arpit, San Diego, California 92121-1714 (US); MITTAL, Rajat, San Diego, California 92121-1714 (US)
(74) Representative: Dunlop, Hugh Christopher
(86) International application number: PCT/US2016/046130
(87) International publication number: WO 2017/039977

(56) References cited:
- EP-A1- 0 962 853
- EP-A1- 2 075 993
- US-A1- 2014 249 690

## Description

### Field of Disclosure

Disclosed aspects relate to wearable electronic devices. More specifically, exemplary aspects pertain to thermal management of electronic headsets.

### Background

Wearable technology is an increasingly popular field of portable computing devices. Electronic devices which may be worn or attached to a user's person, such as smart watches, electronic headsets, etc., have numerous applications in health and fitness, gaming, navigation, communication, multimedia applications etc. The wearable electronic devices may be designed for standalone use or in conjunction with one or more other devices (e.g., portable devices such as mobile phones, laptops, tablets, etc., and/or stationary devices such as television sets, gaming consoles, network hubs, etc.).

As the number of features and applications of wearable electronic devices increases, complexity of the wearable electronic devices also increases. For example, electronic headsets are known in the art for applications such as gaming, virtual reality, etc. Previously, the electronic headsets were designed as display-only devices which may include display screens, motion sensors, etc., but not include significant processing capabilities, as the processing needs of the headsets may be handled by external devices which need not be portable or tethered to a user's person. However, with advances in technology, electronic headsets are evolving into more self-contained devices which can the entire processing needs or significant portions thereof of the electronic headsets.

Increasing the complexity of the electronic headsets leads to increasing power consumption and accompanying heat generation. For example, a virtual reality headset with an embedded processing system designed to handle a significant portion of the processing needs (e.g., graphics processing, digital signal processing, display drivers, etc.) may start becoming very hot during operation. Since the virtual reality headset is designed to be attached to a user's forehead, for example, the heat generated during operation may become uncomfortable and even unbearable in a relatively short time.

However, it is not possible to integrate active cooling systems (such as fans) into the headsets because such cooling solutions themselves may consume power (which will be recognized as a premium in any portable device), and also generate noise and vibrations recognized as a premium in any portable device), and also generate noise and vibrations which will lead to poor user experience. Thus, the performance of the electronic headsets may be limited, in an effort to control thermal characteristics of the electronic devices.

EP 2075993 A1 discusses a mobile terminal for preventing temperature increase of a user-sensitive surface, a display device, and a heat dissipating device for an electronic product based upon user satisfaction. The mobile terminal for preventing temperature increase of a user-sensitive surface includes a user-sensitive surface and a printed circuit board (PCB), in which a heat-insulation layer is located between the user-sensitive surface and the PCB. The display device includes a display screen. A housing having a vacuum space is set on a back side of the display screen. The heat dissipating device for an electronic product based upon user satisfaction includes a thermal-conductive housing set surrounding a PCB and heat-generating components. A user contact area on the thermal-conductive housing is set with heat-insulation structures adapted to reduce the surface temperature of the area.

Therefore, there is a need in the art for better thermal management without compromising on other aspects of wearable electronic devices such as, performance, power, and user experience.

### SUMMARY

Exemplary aspects of the invention are directed to systems and methods for thermal management of electronic headsets such as virtual reality headsets. An electronic headset includes a body which can hold a processing system. A heat spreader is attached to the body, wherein the heat spreader includes a chimney. The heat spreader is designed to dissipate heat generated by the processing system. The heat spreader can be controlled or flexibly deployed by extending or collapsing the chimney based on the temperature of an external surface of the electronic headset, wherein the external surface can come in contact with a user's skin. The chimney includes an air gap and provides a passive cooling system.

An exemplary aspect is directed to an electronic headset as set out in claim 1.

Another exemplary aspect is directed to a method of thermal management of an electronic headset as set out in claim 10.

### BRIEF DESCRIPTION OF THE DRAWINGS

The accompanying drawings are presented to aid in the description of aspects of the invention and are provided solely for illustration of the aspects and not limitation thereof.
FIG. 1A illustrates a schematic top view of a conventional electronic headset.
FIG. 1B illustrates a process for thermal management of the electronic headset of FIG. 1A.
FIG. 2A illustrates a schematic top view of an exemplary electronic headset including a heat spreader.
FIG. 2B illustrates a process for thermal management of the exemplary electronic headset of FIG. 2A.
FIG. 3 illustrates another process of thermal management according to aspects of this disclosure.
FIG. 4 illustrates an exemplary wireless device in which an aspect of the disclosure may be advantageously employed.

### DETAILED DESCRIPTION

Aspects of the invention are disclosed in the following description and related drawings directed to specific aspects of the invention. Alternate aspects may be devised without departing from the scope of the invention. Additionally, well-known elements of the invention will not be described in detail or will be omitted so as not to obscure the relevant details of the invention.

The word "exemplary" is used herein to mean "serving as an example, instance, or illustration." Any aspect described herein as "exemplary" is not necessarily to be construed as preferred or advantageous over other aspects. Likewise, the term "aspects of the invention" does not require that all aspects of the invention include the discussed feature, advantage or mode of operation.

The terminology used herein is for the purpose of describing particular aspects only and is not intended to be limiting of aspects of the invention. As used herein, the singular forms "a", "an" and "the" are intended to include the plural forms as well, unless the context clearly indicates otherwise. It will be further understood that the terms "comprises", "comprising,", "includes" and/or "including", when used herein, specify the presence of stated features, integers, steps, operations, elements, and/or components, but do not preclude the presence or addition of one or more other features, integers, steps, operations, elements, components, and/or groups thereof.

Further, many aspects are described in terms of sequences of actions to be performed by, for example, elements of a computing device. It will be recognized that various actions described herein can be performed by specific circuits (e.g., application specific integrated circuits (ASICs)), by program instructions being executed by one or more processors, or by a combination of both. Additionally, these sequence of actions described herein can be considered to be embodied entirely within any form of computer readable storage medium having stored therein a corresponding set of computer instructions that upon execution would cause an associated processor to perform the functionality described herein. Thus, the various aspects of the invention may be embodied in a number of different forms, all of which have been contemplated to be within the scope of the claimed subject matter. In addition, for each of the aspects described herein, the corresponding form of any such aspects may be described herein as, for example, "logic configured to" perform the described action.

Exemplary aspects are directed to a heat spreader for wearable electronic devices. For example, a heat spreader for an electronic headset is disclosed, where the heat spreader can include a hollow chimney provided within a head strap of the electronic headset. The heat spreader can be attached or coupled to an outside portion of the headset, where an opposite, inside portion of the headset is closer to the forehead of a user. The heat spreader, as well as the headset can be enclosed in an enclosure made of insulating material such as rubber. Thus, the portion of the headset which comes in contact with the user's forehead will be provided within the insulating rubber enclosure.

The heat spreader is designed to dissipate heat generated by the headset. For example, the headset can include an embedded processing system (e.g., designed as a system-on-a-chip (SoC) on a semiconductor chip or die). The heat generated by the processing system, e.g., during operation of the headset, can be transferred to the heat spreader on the outside portion of the headset, thus preventing the inside portion of the headset which is closer to the user, from getting over heated.

In exemplary aspects, the size of the chimney provided in the heat spreader can be controlled (e.g., the chimney can be extended or retracted/collapsed). A control system or state machine can be implemented to control the size of the chimney based on temperatures sensed at various parts of the headset. The combination of the heat spreader and the head set allows the heat generated by the processing system to be higher than the heat which appears at the inside portion which can be in contact with the user's skin. In further aspects, an outer portion of the heat spreader can be covered in another insulating layer (e.g., a transparent, flexible nylon layer) to allow for better radiation heat transfer from the heat spreader to air. In this way, the outer portion of the heat spreader will also be prevented from becoming too hot (e.g., hotter than a specified threshold) to the user's touch. Accordingly, the exemplary, flexible heat spreader can improve thermal management and performance of the headset, without adding to power consumption, noise, vibrations, etc., of the headset.

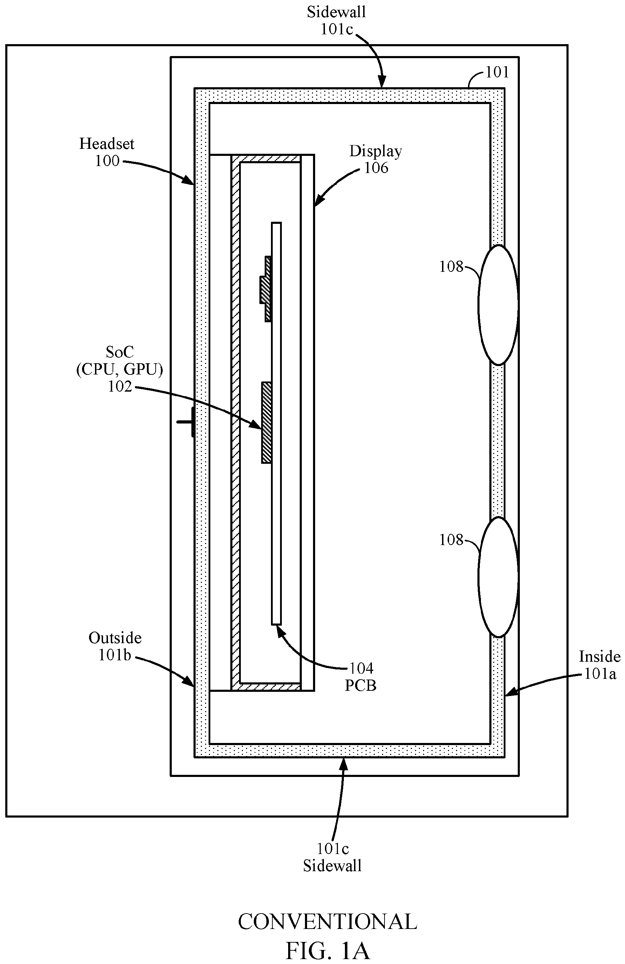

With reference now to FIG. 1A, a conventional headset 100 will first be described. FIG. 1A provides a schematic top view of headset 100, which can be an electronic headset (e.g., as used in any application known in the art, such as for multimedia, gaming, virtual reality, etc.) As such, headset 100 can include a body, identified by the reference numeral 100. Body 101 can include any casing or housing which can be placed or worn on a user's person (e.g., forehead), and may be secured by a head strap (not shown). Body 101 can be made of materials such as plastic. Eyes 108 of the user are shown to indicate that body 101 can be in contact with the user's forehead. A first portion of body 101 that is closer to or in contact with the user's person is identified as inside 101a, and the opposite side, which is an external portion and away from the user's person is identified as outside 101b. Sidewalls 101c couple the two portions, inside 101a and outside 101b of body 101.

Headset 100 can include display 106 that the user can see. Display 106 may be any suitable display enclosed or provided within body 101, such as liquid crystal display (LCD), liquid crystal on silicon (LCO), light-emitting diode (LED), organic LED (OLED), etc. Headset 100 is also shown to include a processing system designated by the reference identifier 102. Processing system 102 can be integrated on printed circuit board (PCB) 104 or any other semiconductor chip or die. Processing system 102 can be any special or general purpose processor, and may be designed as a system-on-a-chip (SoC) capable of handling at least a significant portion of the processing performed by headset 100. As such, processing system 102 can include one or more of a central processing unit (CPU), a graphics processing unit (GPU), a digital signal processor (DSP), display drivers, etc.

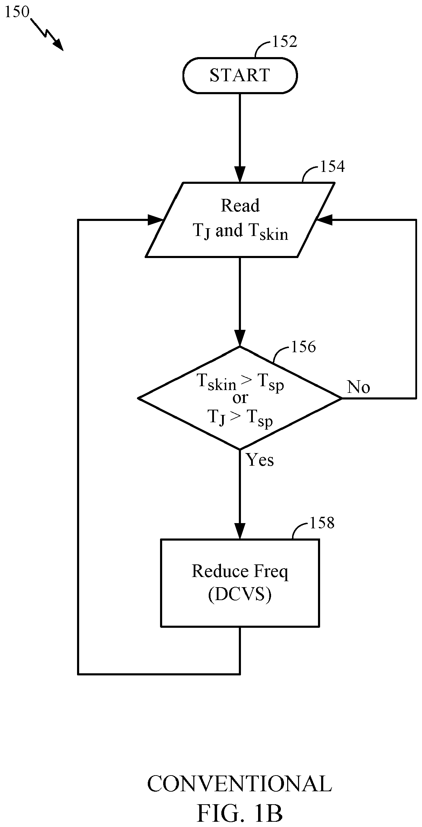

In headset 100, processing system 102 can generate heat, and the amount of heat generated can be proportional to the performance or frequency of operation. The amount of heat generated leads to increase in temperature. The temperature at the processing system (e.g., on PCB 104) is referred to as a junction temperature (T_{J}), while the temperature at body 101 that can be perceived by a user is referred to as a skin temperature (Tₛₖᵢₙ). The skin temperature Tₛₖᵢₙ should not be allowed to increase beyond a certain temperature, referred to as a set point temperature (T_{SP}), to prevent discomfort or worse, burns or injuries to the user. A control system may be in place to monitor and control thermal management of headset 100. A process that may be employed by the control system will be described with reference to FIG. 1B.

In FIG. 1B, a flow chart representation of an algorithm or process of thermal management is illustrated and generally depicted as 150. Process 150 begins at start block 152 and proceeds to block 154 where T_{J} and Tₛₖᵢₙ are both read or sensed (e.g., by the use of temperature sensors configured to measure the temperature of PCB 104 and any part of body 101, respectively). It is assumed for the sake of this discussion that all portions of body 101 heat up uniformly as T_{J} increases and transfers heat to body 101, although it is possible for body 101 to be made up of or include different components or elements which may not all heat up at the same rate. Alternatively, the temperature of any representative part of body 101 that can be touched by the user, and whose temperature should be monitored, is sensed and referred to as Tₛₖᵢₙ.

Since all of the heat generated by processing system 102 will be transferred to body 101, it is important to ensure that neither T_{J} nor Tₛₖᵢₙ rise beyond T_{SP}. Thus at block 156, it is determined whether either T_{J} > T_{SP} or Tₛₖᵢₙ > T_{SP}. If either of these conditions are true, i.e., T_{J} > T_{SP} or Tₛₖᵢₙ > T_{SP}, then in block 158, frequency of operation of processing system 102 is reduced. For example, block 158 may implement a dynamic clock frequency and voltage scaling (DCVS) mechanism to scale down the frequency and/or voltage in an attempt to reduce the heat generated by processing system 102. Process 150 then returns to block 154 to see if block 158 achieved its intended purpose of bringing down both T_{J} and Tₛₖᵢₙ under T_{SP}, and thereon blocks 154-156 are repeated until both T_{J} < T_{SP} and Tₛₖᵢₙ < T_{SP}. If both T_{J} < T_{SP} and Tₛₖᵢₙ < T_{SP}, then process 150 goes from block 156 to block 154, to monitor T_{J} and Tₛₖᵢₙ. As seen from process 150, the performance of processing system 102 (e.g., based on frequency and voltage) is limited by both T_{J} and Tₛₖᵢₙ. Based on particular applications and specified values of T_{SP}, user experience can deteriorate when performance of processing system 102 falls.

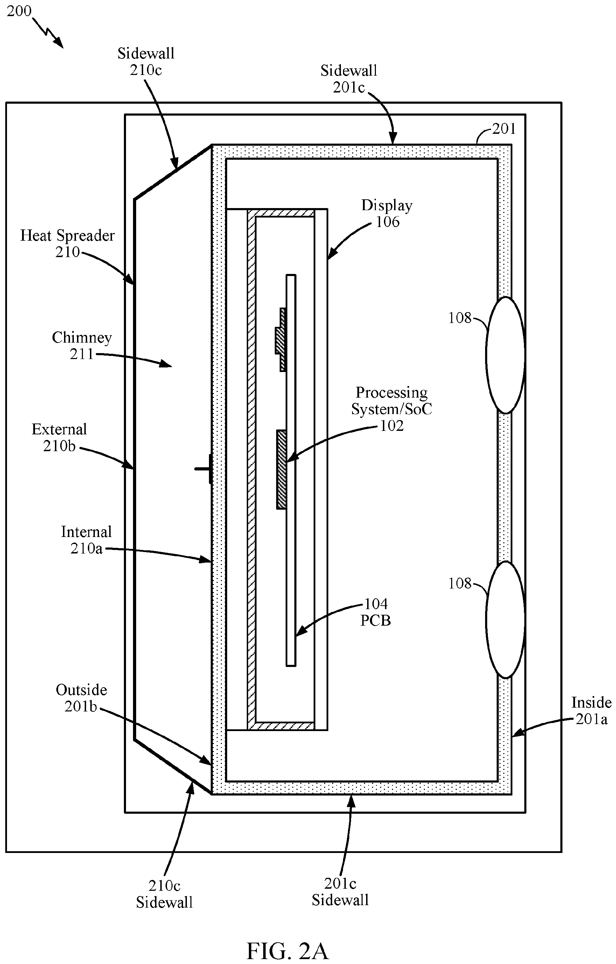

In order to improve temperature and performance (or thermal performance) of electronic headsets, exemplary aspects include a heat spreader, as previously mentioned. An exemplary heat spreader and related aspects will be described with reference to FIGS. 2A-B below. In FIGS. 2A-B, like reference numerals from FIGS. 1A-B have been retained for identifying similar components. Thus, the discussion below will focus on significant differences between FIGS. 2A-B and FIGS. 1A-B without an exhaustive repetition of similar features with like reference numerals, for the sake of brevity.

Accordingly, with reference first to FIG. 2A, a schematic top view of exemplary headset 200 is shown. Processing system 102, PCB 104, and display 106 of headset 200 may be configured similar to headset 100 shown in FIG. 1A. Headset 200 may also be an electronic device like headset 100 (e.g., as used in any application known in the art, such as for multimedia, gaming, virtual reality, etc.) which can be worn by a user whose eyes 108 are depicted in the schematic of FIG. 2A.

As seen, headset 200 includes body 201 and heat spreader 210, which are configured according to exemplary aspects and will be further described in detail below. In exemplary aspects, body 201 can include means for encasing processing system 102 of headset 200 and heat spreader 210 can comprise means for dissipating heat generated by processing system 102.

Accordingly, in exemplary aspects, body 201 can include outside portion 201b, inside portion 201a, and sidewalls 201c. Outside portion 201b can be separated from or displaced by a distance corresponding to sidewalls 201c from inside portion 201a of body 201, where inside portion 201a may be contactable by the user (e.g., the user's forehead) when headset 200 is worn by the user.

Heat spreader 210 can be attached to outside portion 201b of body 201. Heat spreader 210 can be designed as or include chimney 211, which is a hollow portion or air gap with the top and bottom open in the schematic top view of FIG. 2A. More specifically, heat spreader 210 includes sides identified as external side 210b, internal side 210a, and sidewalls 210c. Chimney 211 is formed in the hollow region enclosed by internal surfaces of external side 210b, internal side 210a, and sidewalls 210c, but open on the top and bottom sides as noted. External side 210b, internal side 210a, and/or sidewalls 210c of heat spreader 210 can be made of a conductor such as metal. At least a portion of the external surfaces of heat spreader 210, e.g., external side 210b and/or sidewalls 210c, may also be enclosed in a rubber casing or housing. A user's skin may come in contact with the external surfaces of external side 210b and/or sidewalls 210c of heat spreader 210 (e.g., while handling headset 200), and the rubber casing provides heat insulation.

The size of chimney 211 is adjustable, such that chimney 211 can be extended when an external surface temperature of the headset perceivable by a user's skin (also referred to as the skin temperature Tₛₖᵢₙ exceeds a threshold temperature or set point temperature T_{SP}. Chimney 211 can remain collapsed when the external surface temperature does not exceed the threshold temperature. For example, the size of chimney 211 can be controlled by extending or collapsing sidewalls 210c of heat spreader 210. When chimney 211 is collapsed, external side 210b can be close to or in contact with internal side 210a, based on sidewalls 210c being collapsed. When sidewalls 210 are extended, chimney 211 is deployed. The more sidewalls 210c are extended, the bigger the region covered by chimney 211. In some cases, sidewalls 210c may be configured in only two states: fully extended or fully retracted, where, correspondingly, chimney 211 is deployed, operational, and in use or fully collapsed and not in use, respectively. In some cases, more flexible control may be possible to extend sidewalls 210 to a controllable length between the two extreme states of fully extended or fully retracted, where, correspondingly, the size of chimney 211 can also be flexibly adjusted between fully deployed and fully collapsed.

Heat spreader 210 comprising chimney 211 can be coupled to or attached to outside portion 201b of body 201 of headset 200. Outside portion 201b of body 201 can be formed from a heat conducting material such as a metal plate. Heat generated by processing system 102 is transferred from outside portion 201b (metal plate) of body 201 to internal side 210a of heat spreader 210. The generated heat may spread to external side 210b and/or sidewalls 210c of heat spreader 210, but will be dissipated from internal surfaces of external side 210b, internal side 210a, and sidewalls 210c of heat spreader 210, by chimney 211 into the open air. Thus, the external surfaces of heat spreader 210 (e.g., external side 210b and/or sidewalls 210c which may be enclosed in a rubber casing, as noted above) will be protected from the heat generated by processing system 102 due to the dissipation of heat by chimney 211 (and if provided, the rubber casing on external surfaces of external side 210b and/or sidewalls 210c).

The remaining portions of body 201 which can come in contact with the user's skin, such as sidewall 201c and inside portion 201a of body 201 will also be protected from heat generated by processing system 102 due to heat dissipation provided by chimney 211. Further, these remaining portions (i.e., sidewall 201c and inside portion 201a of body 201) can also be made of or be enclosed in an insulating material such as rubber or plastic to provide further heat insulation.

Accordingly, chimney 211 can provide a passive cooling system (i.e., without requiring active cooling elements such as a fan) which does not consume active power, generate noise, vibrations, etc. Since chimney 211 draws the heat away from portions of body 201 (e.g., inside portion 201a) which can be in significant contact with the user's skin (e.g., eyes 108 connected to the user's forehead), the temperature of processing system 102 can rise beyond the temperature that will be perceived by the user.

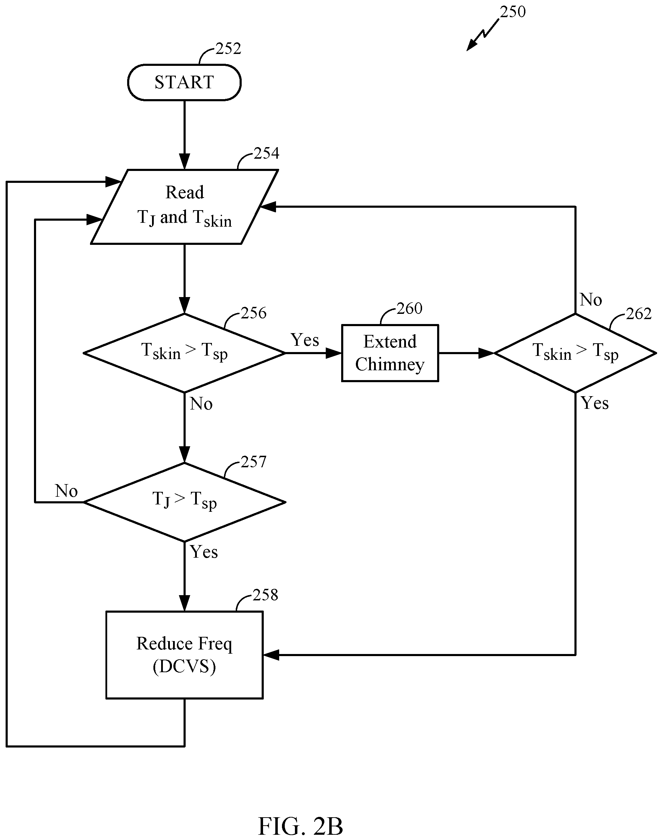

Considering FIG. 2B, a flow chart of process 250, according to exemplary aspects is illustrated. Process 250 can be performed by a control system such as an application specific integrated circuit (ASIC) provided in headset 200 or other means for flexibly deploying heat spreader 210 comprising chimney 211 according to aspects of this disclosure. In one example, such a control system, ASIC or means for flexibly deploying can be integrated on PCB 104, for example, and may be in communication with temperature sensors to sense junction temperature (T_{J}) at PCB 104 and skin temperature (Tₛₖᵢₙ) at any external surface (e.g., external surface of external side 210b, sidewalls 210c of heat spreader 210, and/or sidewalls 201c, inside portion 201a of body 201) which can come in contact with a user's skin. The control system may be configured to control deployment (and in relevant aspects, size of chimney 211) based on comparisons of Tₛₖᵢₙ and T_{J} to set point temperature T_{SP}. In headset 200, T_{J} can reach higher temperatures possible in conventional implementations, which means that performance of headset 200 can be improved. Overall, headset 200 is configured for enhanced thermal performance in this manner.

In further detail, process 250 starts at block 252 and proceeds to block 254 for reading or monitoring Tₛₖᵢₙ and T_{J} (e.g., from the aforementioned sensors). In decision block 256, it is determined whether Tₛₖᵢₙ > T_{SP}, and if yes, the control system may flexibly deploy heat spreader 210, for example, by extending chimney 211, as shown in block 260. In decision block, it is determined whether block 260 fixed the problem, i.e., if Tₛₖᵢₙ continues to be greater than T_{SP}. If the problem was fixed and Tₛₖᵢₙ < T_{SP} (i.e., Tₛₖᵢₙ > T_{SP} is not true), then process 250 returns to block 254 to continue monitoring Tₛₖᵢₙ and T_{J}. On the other hand, if block 260 did not fix the problem and Tₛₖᵢₙ > T_{SP} in block 262, then process 250 proceeds to block 258 where performance or frequency of processing system 102 is reduced (e.g., by using DCVS mechanisms as noted above). Accordingly, a frequency reduction in block 258 is initiated based on Tₛₖᵢₙ > T_{SP} only after first deploying chimney 211 in block 260.

Revisiting decision block 256, if Tₛₖᵢₙ > T_{SP} is not true (i.g., Tₛₖᵢₙ < T_{SP}), then process 250 proceeds to decision block 257, where it is determined whether T_{J} > T_{SP}. If T_{J} > T_{SP}, then once again, a frequency reduction is performed in block 258. If T_{J} is not greater than T_{SP}, process 250 returns to block 254 to continue monitoring Tₛₖᵢₙ and T_{J}. Thus, reducing frequency in block 258 is controlled by T_{J} but not Tₛₖᵢₙ. In other words, junction temperature (T_{J}) at PCB 104 can be allowed to increase until a threshold (e.g., T_{SP}) before frequency reduction is performed, rather than having to reduce frequency when skin temperature (Tₛₖᵢₙ) reaches the threshold T_{SP} (unless the chimney has first been extended at block 260 and Tₛₖᵢₙ increased above T_{SP} in block 262). This provides an advantage over conventional methods described with reference to FIG. 1B which may be limited by having to reduce frequency when either Tₛₖᵢₙ or T_{J} increased above T_{J} (e.g., block 156 of FIG. 1B).

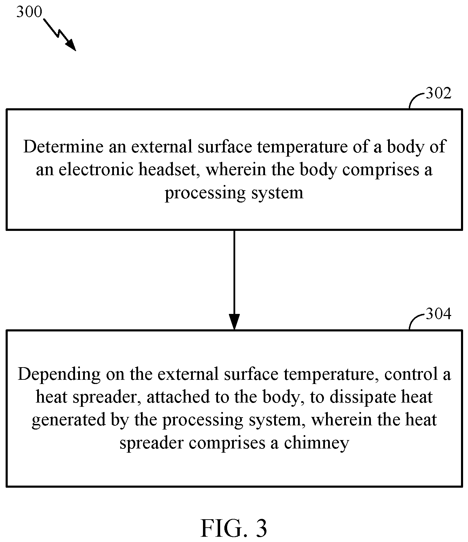

Accordingly, it will be appreciated that exemplary aspects include various methods for performing the processes, functions and/or algorithms disclosed herein. For example, as shown in FIG. 3, method 300 pertains to method of thermal management of an electronic headset, e.g., headset 200.

In Block 302, method 300 comprises determining an external surface temperature of a body of the electronic headset, wherein the body comprises a processing system. For example, in Block 302 temperature sensors can be used to determine the external surface temperature or Tₛₖᵢₙ of body 201 of head set 200, wherein body 201 comprises processing system 102.

In Block 304, depending on the external surface temperature, a heat spreader attached to the body is controlled to dissipate heat generated by the processing system, wherein the heat spreader comprises a chimney. For example, in Block 304, heat spreader 210 may be flexibly deployed to dissipate heat generated by processing system 102. For example, chimney 211 of heat spreader 210 can be extended (e.g., as shown and described with relation to the control system in blocks 260 and 262 of FIG. 2B, for deploying chimney 211) if the external surface temperature of the headset, e.g., skin temperature Tₛₖᵢₙ perceivable by a user's skin, exceeds a threshold temperature (e.g., set point temperature T_{SP}). On the other hand, chimney 211 can be retracted or remain collapsed if the external surface temperature does not exceed the threshold temperature.

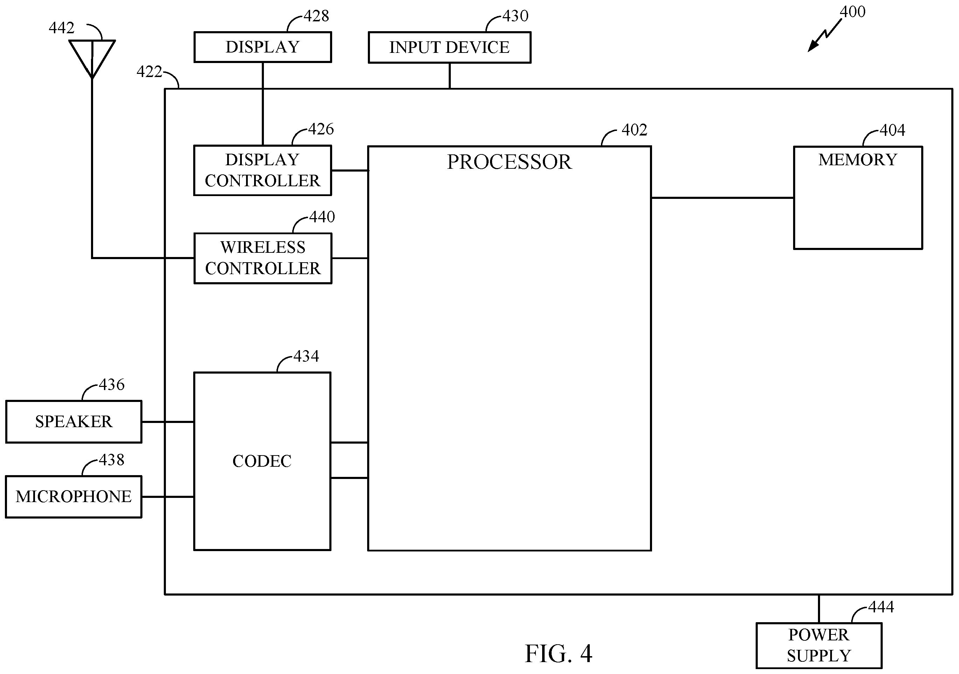

Referring now to FIG. 4, a block diagram of a particular illustrative aspect of wireless device 400 configured according to exemplary aspects, is illustrated. Wireless device 400 may include or correspond to headset 200 described with reference to FIGS. 2A-B and be configured according to method 300 of FIG. 3. Wireless device 400 is shown to include a processing system or system-on-chip (SoC) device 422, which may be similar to processing system 102 described previously. As such, wireless device 400, or more specifically, system-on-chip (SoC) device 422 includes processor 402 (which may be a general purpose processor, a digital signal processor (DSP), a graphics core, etc. configured to execute instructions pertaining to electronic headsets as described in this disclosure). Processor 402 may be in communication with memory 404. Although not shown separately, one or more caches or other memory structures may also be included in wireless device 400.

FIG. 4 also shows display controller 426 that is coupled to processor 402 and to display 428. Coder/decoder (CODEC) 434 (e.g., an audio and/or voice CODEC) can be coupled to processor 402. Other components, such as wireless controller 440 (which may include a modem) are also illustrated. Speaker 436 and microphone 438 can be coupled to CODEC 434. FIG. 4 also indicates that wireless controller 440 can be coupled to wireless antenna 442. Display controller 426 is also shown, which may control display 428 (which may be similar to display 106 described previously). In a particular aspect, processor 402, display controller 426, memory 404, CODEC 434, and wireless controller 440 are included in the system-in-package or system-on-chip device 422.

In a particular aspect, input device 430 and power supply 444 are coupled to the system-on-chip device 422. Moreover, in a particular aspect, as illustrated in FIG. 4, display 428, input device 430, speaker 436, microphone 438, wireless antenna 442, and power supply 444 are external to the system-on-chip device 422. However, each of display 428, input device 430, speaker 436, microphone 438, wireless antenna 442, and power supply 444 can be coupled to a component of the system-on-chip device 422, such as an interface or a controller.

It should be noted that although FIG. 4 depicts a wireless communications device, processor 402 and memory 404 may also be integrated into an electronic headset, a set top box, a music player, a video player, an entertainment unit, a navigation device, a personal digital assistant (PDA), a communications device, a fixed location data unit, or a computer. Further, at least one or more exemplary aspects of wireless device 400 may be integrated in at least one semiconductor die.

Those of skill in the art will appreciate that information and signals may be represented using any of a variety of different technologies and techniques. For example, data, instructions, commands, information, signals, bits, symbols, and chips that may be referenced throughout the above description may be represented by voltages, currents, electromagnetic waves, magnetic fields or particles, optical fields or particles, or any combination thereof.

Further, those of skill in the art will appreciate that the various illustrative logical blocks, modules, circuits, and algorithm steps described in connection with the aspects disclosed herein may be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present invention.

The methods, sequences and/or algorithms described in connection with the aspects disclosed herein may be embodied directly in hardware, in a software module executed by a processor, or in a combination of the two. A software module may reside in RAM memory, flash memory, ROM memory, EPROM memory, EEPROM memory, registers, hard disk, a removable disk, a CD-ROM, or any other form of storage medium known in the art. An exemplary storage medium is coupled to the processor such that the processor can read information from, and write information to, the storage medium. In the alternative, the storage medium may be integral to the processor.

Accordingly, an aspect of the invention can include a computer readable media embodying a method of thermal management of an electronic headset. Accordingly, the invention is not limited to illustrated examples and any means for performing the functionality described herein are included in aspects of the invention.

While the foregoing disclosure shows illustrative aspects of the invention, it should be noted that various changes and modifications could be made herein without departing from the scope of the invention as defined by the appended claims. The functions, steps and/or actions of the method claims in accordance with the aspects of the invention described herein need not be performed in any particular order. Furthermore, although elements of the invention may be described or claimed in the singular, the plural is contemplated unless limitation to the singular is explicitly stated.

## Claims

1. An electronic headset (100, 200) comprising:
a body (101, 201) comprising a processing system (102); and
a heat spreader (210) attached to the body (101, 201), the heat spreader (210) comprising a chimney (211) configured to dissipate heat generated by the processing system, **characterized in that**:
an internal side (210a) of the heat spreader is attached to the body, and wherein the heat spreader (210) further comprises an external side (210b) coupled to the internal side of the heat spreader by sidewalls of the heat spreader (210), and
wherein a size of the chimney is adjustable, such that the chimney is deployed if an external surface temperature of the electronic headset, perceivable by a user's skin, exceeds a threshold temperature and the chimney (211) is collapsed if the external surface temperature does not exceed the threshold temperature.

2. The electronic headset of claim 1, wherein the heat spreader (210) is attached to an outside portion of the body (101, 201), wherein the outside portion is displaced from an inside portion of the body contactable by a user's forehead.

3. The electronic headset of claim 2, wherein the outside portion of the body (101, 201) comprises a metal plate.

4. The electronic headset of claim 1, wherein the sidewalls of the heat spreader (210) are extended when the chimney (211) is deployed, and the sidewalls of the heat spreader (210) are collapsed when the chimney (211) is collapsed.

5. The electronic headset of claim 1, wherein a temperature of the processing system is greater than the external surface temperature.

6. The electronic headset of claim 1, comprising a control system configured to adjust the size of the chimney based on the external surface temperature.

7. The electronic headset of claim 1, wherein at least a portion of the heat spreader (210) is enclosed in a rubber casing.

8. The electronic headset of claim 1, wherein the chimney (211) comprises an air gap.

9. The electronic headset of claim 1 configured for one or more of gaming, multimedia, or virtual reality applications.

10. A method (300) of thermal management of an electronic headset (100, 200), the method comprising:
determining (302) an external surface temperature of a body (101, 201) of the electronic headset, wherein the body comprises a processing system (102, 202); and
depending (304) on the external surface temperature, controlling a heat spreader (210), attached to the body, to dissipate heat generated by the processing system, wherein the heat spreader comprises a chimney (211), **characterized by**
attaching an internal side (210a) of the heat spreader to the body, and wherein the heat spreader further comprises an external side (210b) coupled to the internal side of the heat spreader (210) by sidewalls of the heat spreader (210), and
wherein controlling the heat spreader comprises adjusting a size of the chimney, by deploying the chimney (211) if the external surface temperature of the electronic headset, perceivable by a user's skin, exceeds a threshold temperature; and collapsing the chimney (211) if the external surface temperature does not exceed the threshold temperature.

11. The method of claim 10, wherein the heat spreader (210) is attached to an outside portion of the body, wherein the outside portion is displaced from an inside portion of the body (101, 201) which is contactable by a user's forehead.

12. The method of claim 11, wherein the outside portion of the body (101, 201) comprises a metal plate.

13. The method of claim 10, comprising deploying the chimney (211) by extending the sidewalls of the heat spreader (210), and collapsing the chimney (211) by collapsing the sidewalls of the heat spreader.

14. The method of claim 10, wherein a temperature of the processing system is greater than the external surface temperature.

## Patentansprüche

1. Ein elektronisches Headset (100, 200), aufweisend:
einen Körper (101, 201), der ein Verarbeitungssystem (102) aufweist, und
einen Wärmespreizer (210), der an dem Körper (101, 201) angebracht ist, wobei der Wärmespreizer (210) einen Abzug (211) aufweist, der konfiguriert ist zum Abführen von durch das Verarbeitungssystem erzeugter Wärme,
**dadurch gekennzeichnet, dass**:
eine Innenseite (210a) des Wärmespreizers an dem Körper befestigt ist, wobei der Wärmespreizer (210) weiterhin eine Außenseite (210b) aufweist, die mit der Innenseite des Wärmespreizers durch Seitenwände des Wärmespreizers (210) gekoppelt ist, und
wobei die Größe des Abzugs einstellbar ist, sodass der Abzug entfaltet wird, wenn eine Außenflächentemperatur des elektronischen Headsets, die durch die Haut eines Benutzers wahrgenommen werden kann, eine Schwellwertemperatur übersteigt, und der Abzug kollabiert, wenn die Außenflächentemperatur die Schwellwerttemperatur nicht übersteigt.

2. Elektronisches Headset nach Anspruch 1, wobei der Wärmespreizer (210) an einem äußeren Teil des Körpers (101, 201) angebracht ist, wobei der äußere Teil von einem inneren Teil des Körpers, der in Kontakt mit der Stirn eines Benutzers gebracht wird, versetzt ist.

3. Elektronisches Headset nach Anspruch 2, wobei der äußere Teil des Körpers (101, 201) eine Metallplatte aufweist.

4. Elektronisches Headset nach Anspruch 1, wobei die Seitenwände des Wärmespreizers (210) ausgefaltet werden, wenn der Abzug (211) entfaltet wird, und die Seitenwände des Wärmespreizers (210) kollabieren, wenn der Abzug (211) kollabiert.

5. Elektronisches Headset nach Anspruch 1, wobei die Temperatur des Verarbeitungssystems größer ist als die Außenflächentemperatur.

6. Elektronisches Headset nach Anspruch 1, das ein Steuersystem aufweist, das konfiguriert ist zum Einstellen der Größe des Abzugs basierend auf der Außenflächentemperatur.

7. Elektronisches Headset nach Anspruch 1, wobei wenigstens ein Teil des Wärmespreizers (210) in einem Gummigehäuse eingeschlossen ist.

8. Elektronisches Headset nach Anspruch 1, wobei der Abzug (211) einen Luftspalt aufweist.

9. Elektronisches Headset nach Anspruch 1, das für Spiele-, Multimedia- oder Virtual Reality-Anwendungen konfiguriert ist.

10. Ein Verfahren (300) für eine Wärmeverwaltung eines elektronischen Headsets (100, 200), wobei das Verfahren aufweist:
Bestimmen (302) einer Außenflächentemperatur eines Körpers (101, 201) des elektronischen Headsets, wobei der Körper ein Verarbeitungssystem (102, 202) aufweist, und
in Abhängigkeit von der Außenflächentemperatur, Steuern (304) eines Wärmespreizers (210), der an dem Körper angebracht ist, zum Abführen von durch das Verarbeitungssystem erzeugter Wärme, wobei der Wärmespreizer einen Abzug (211) aufweist,
**gekennzeichnet durch**:
Befestigen einer Innenseite (210a) des Wärmespreizers an dem Körper, wobei der Wärmespreizer weiterhin eine Außenseite (210b) aufweist, die mit der Innenseite des Wärmespreizers (210) durch Seitenwände des Wärmespreizers (210) gekoppelt ist, und
wobei das Steuern des Wärmespreizers das Einstellen der Größe des Abzugs durch das Entfalten des Abzugs (211), wenn die Außenflächentemperatur des elektronischen Headsets, die durch die Haut eines Benutzers wahrgenommen werden kann, eine Schwellwerttemperatur übersteigt, und das Kollabieren des Abzugs (211), wenn die Außenflächentemperatur die Schwellwerttemperatur nicht überschreitet.

11. Verfahren nach Anspruch 10, wobei der Wärmespreizer (210) an einem äußeren Teil des Körpers angebracht wird, wobei der äußere Teil von einem inneren Teil des Körpers (101, 201), der in Kontakt mit der Stirn eines Benutzers gebracht wird, versetzt ist.

12. Verfahren nach Anspruch 11, wobei der äußere Teil des Körpers (101, 201) eine Metallplatte aufweist.

13. Verfahren nach Anspruch 10, das das Entfalten des Abzugs (211) durch das Ausfalten der Seitenwände des Wärmespreizers (210) und das Kollabieren des Abzugs (211) durch das Kollabieren der Seitenwände des Wärmespreizers aufweist.

14. Verfahren nach Anspruch 10, wobei die Temperatur des Verarbeitungssystems größer ist als die Außenflächentemperatur.

## Revendications

1. Casque électronique (100, 200) comprenant :
un corps (101, 201) comprenant un système de traitement (102) ; et
un dissipateur thermique (210) attaché au corps (101, 201), le dissipateur thermique (210) comprenant une cheminée (211) configurée pour dissiper la chaleur générée par le système de traitement, **caractérisé en ce que**
un côté interne (210a) du dissipateur thermique est attaché au corps, et dans lequel le dissipateur thermique (210) comprend en outre un côté externe (210b) couplé au côté interne du dissipateur thermique par des parois latérales du dissipateur thermique (210), et
dans lequel une taille de la cheminée est réglable, de telle sorte que la cheminée soit déployée si une température de surface externe du casque électronique, pouvant être perçue par la peau d'un utilisateur, dépasse une température seuil et la cheminée (211) est rétractée si la température de surface externe ne dépasse pas la température seuil.

2. Casque électronique selon la revendication 1, dans lequel le dissipateur thermique (210) est attaché à une partie extérieure du corps (101, 201), dans lequel la partie extérieure est déplacée par rapport à une partie intérieure du corps avec laquelle le front d'un utilisateur peut faire contact.

3. Casque électronique selon la revendication 2, dans lequel la partie extérieure du corps (101, 201) comprend une plaque métallique.

4. Casque électronique selon la revendication 1, dans lequel les parois latérales du dissipateur thermique (210) sont étendues quand la cheminée (211) est déployée, et les parois latérales du dissipateur thermique (210) sont rétractées quand la cheminée (211) est rétractée.

5. Casque électronique selon la revendication 1, dans lequel une température du système de traitement est supérieure à la température de surface externe.

6. Casque électronique selon la revendication 1, comprenant un système de commande configuré pour régler la taille de la cheminée en fonction de la température de surface externe.

7. Casque électronique selon la revendication 1, dans lequel au moins une partie du dissipateur thermique (210) est enfermée dans un boîtier en caoutchouc.

8. Casque électronique selon la revendication 1, dans lequel la cheminée (211) comprend un espace d'air.

9. Casque électronique selon la revendication 1 configuré pour une ou plusieurs applications de jeu, multimédia ou de réalité virtuelle.

10. Procédé (300) de gestion thermique d'un casque électronique (100, 200), le procédé comprenant :
la détermination (302) d'une température de surface externe d'un corps (101, 201) du casque électronique, le corps comprenant un système de traitement (102, 202) ; et
en fonction (304) de la température de surface externe, la commande d'un dissipateur thermique (210), attaché au corps, pour dissiper la chaleur générée par le système de traitement, dans lequel le dissipateur thermique comprend une cheminée (211), **caractérisé par**
la fixation d'un côté interne (210a) du dissipateur thermique au corps, et dans lequel le dissipateur thermique comprend en outre un côté externe (210b) couplé au côté interne du dissipateur thermique (210) par des parois latérales du dissipateur thermique (210), et
dans lequel la commande du dissipateur thermique comprend le réglage d'une taille de la cheminée, en déployant la cheminée (211) si la température de surface externe du casque électronique, pouvant être perçue par la peau d'un utilisateur, dépasse une température seuil ; et rétractant la cheminée (211) si la température de surface externe ne dépasse pas la température seuil.

11. Procédé selon la revendication 10, dans lequel le dissipateur thermique (210) est fixé à une partie extérieure du corps, dans lequel la partie extérieure est déplacée par rapport à une partie intérieure du corps (101, 201) avec laquelle le front d'un utilisateur peut faire contact.

12. Procédé selon la revendication 11, dans lequel la partie extérieure du corps (101, 201) comprend une plaque métallique.

13. Procédé selon la revendication 10, comprenant le déploiement de la cheminée (211) en étendant les parois latérales du dissipateur thermique (210), et la rétraction de la cheminée (211) en rétractant les parois latérales du dissipateur thermique.

14. Procédé selon la revendication 10, dans lequel une température du système de traitement est supérieure à la température de surface externe.
